Europäisches Patentamt

(19) European Patent Office

Office européen des brevets

(11) Publication number: **0 032 130**

A1

(12) **EUROPEAN PATENT APPLICATION**

(21) Application number: **81300029.6**

(22) Date of filing: **06.01.81**

(51) Int. Cl.³: **G 01 R 23/15**
**H 04 B 5/04**

(30) Priority: **07.01.80 GB 8000357**

(43) Date of publication of application:
**15.07.81 Bulletin 81/28**

(84) Designated Contracting States:
**BE CH DE FR GB IT LI NL SE**

(71) Applicant: **MASTIFF SECURITY SYSTEMS LIMITED**
**Randalls Road**
**Leatherhead, Surrey KT22 7RX(GB)**

(72) Inventor: **Taylor, Derek Reginald**
**24, Beckenshaw Gardens**
**Woodmansterne Banstead Surrey(GB)**

(74) Representative: **Arthur, George Fitzgerald et al,**
**KILBURN & STRODE 30, John Street**
**London WC1N 2DD(GB)**

(54) Radio frequency detector.

(57) The radio frequency detector relates to an access control system for permitting access to be given to persons having tokens transmitting at certain frequencies, but not at other close frequencies. A receiver at the point where access is to be given includes a radio frequency amplifier (B) and a mixer (C) for mixing the amplifier output with a close local frequency signal (D), the output from the mixer being passed through a lowpass filter (E) to counters (F,G) arranged to count over a preset time interval the beat difference frequency and to give an "accept" signal (Z) if the count indicates that a token at the location is transmitting at the particular frequency.

FIG. I.

EP 0 032 130 A1

.1.

## RADIO FREQUENCY DETECTOR

This invention relates to a radio frequency detector for detecting whether a particular frequency of electro-magnetic radiation is present at a particular location, and one object is to provide a detector which can be used where it may be desired to detect whether any one of a number of different frequencies is present, the frequencies being fairly close together so that if two frequencies were present at one time, the detector might be jammed.

According to the present invention, a radio frequency detector includes a radio frequency amplifier and a mixer arranged to mix the amplifier output with an accurate local frequency signal, a low pass filter of the mixer output, and means responsive to the filter output arranged to give an 'accept' or 'refuse' signal in dependence on whether or not a particular frequency or one of a number of particular frequencies is present.

One use of the detector is in an access control system where someone requiring access to certain premises, or to a particular machine, is required to have on his person a radiator of a particular radio-frequency signal, which may be unique to that individual, or certain individuals as distinct from certain other individuals. In such an application it is preferred that the local frequency signal is close to the individual's radio frequency signal on the token he carries on his person. It may be in a small unit which he can carry in his pocket to be transmitting continuously, or possibly to be transmitting when in the vicinity of the access area, so that he can be granted access without having to use his hands to present a token to a lock, or to take any other action.

The output of the mixer will be the sum and difference frequencies between the particular frequency and the local frequency, and the low-pass filter can be arranged to pass from that output only the difference frequency.

Conveniently, the means responsive to the filter output comprises one or more counters arranged to count for a predetermined time, and means for detecting whether the count achieved at the end of that time represents a difference frequency corresponding to the particular radio frequency.

Where the system is to be used to detect any of a number of particular frequencies, there may be a separate counter, set for the difference frequencies for each of the particular frequencies, and their outputs can be coupled through an OR gate which will thus give an output if any of the particular frequencies is present.

In order to avoid the system being jammed if two frequencies are present, which are very little different from each other, the amplifier may be made to lock onto which ever of the frequencies is the stronger. There will then be a single difference frequency produced at the output from the mixer, which will trigger one of the counters and enable an "accept" signal to be given provided the stronger frequency is a particular frequency. That is achieved by making the R.F. amplifier highly selective and preferably with automatic gain control, so that if two frequencies are present, the gain will be turned down and the amplifier output will represent the stronger frequency, whereas if only one weak signal is present, the gain will be turned up, so that the output from that frequency will be supplied to the mixer.

A frequency close to a particular frequency can be easily distinguished from, because the beat difference frequency will be substantially different from that for the particular frequency.

The local oscillator is required to be of constant accurate frequency and is preferably a crystal oscillator.

The invention may be carried into practice in various ways, and one embodiment will now be described by way of example, with reference to the accompanying drawings, of which;

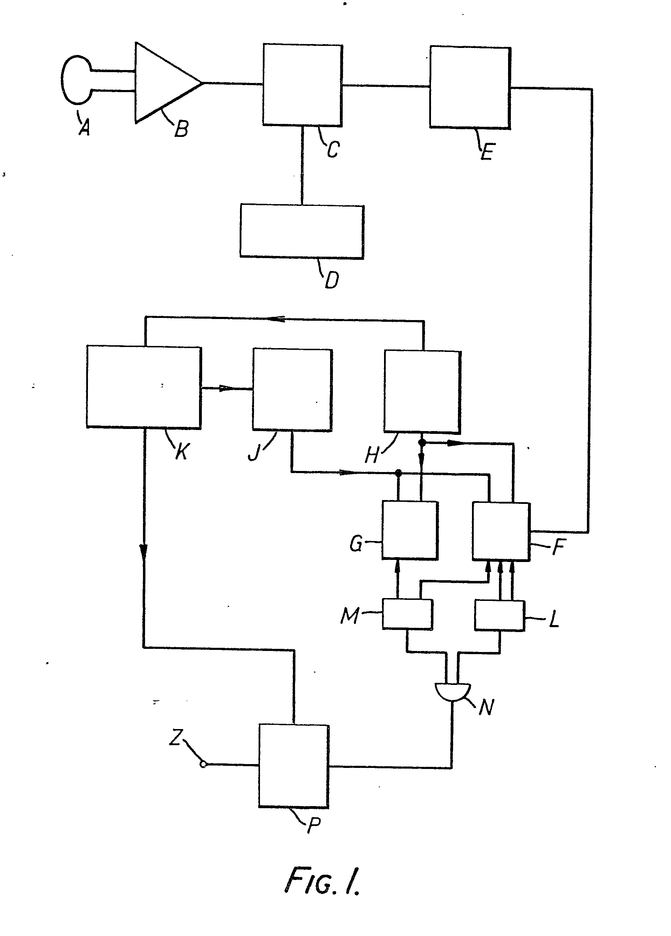

FIGURE 1 is a block diagram of a detector embodying the invention; and

FIGURE 2 is a circuit diagram of an amplifier in the diagram of FIGURE 1.

An inductive aerial 'A' is positioned at an access gate to protected premises, and is required to give an output at 'Z' if and only if a radio frequency signal at any one of four different particular frequencies is picked up at 'A'. In the example being described, the frequencies are 100080, 100032, 99920 and 99968 HZ. Transmitters operating at these frequencies are embodied in pocket units, which are distributed amongst employees in four different levels of security, certain of which are allowed to have access to a controlled area.

At a gate controlled by the arrangement in the Figure, access is to be given to anyone with a token at any one of the four levels, but it is important that an access signal will be given at 'Z' even if two tokens at different levels are present, because two such individuals want to come in together.

The aerial 'A' feeds a radio-frequency amplifier 'B' which has high selectivity at the mean frequency of 100 KhZ, with automatic gain control, and the output of which is mixed at 'C' with local frequency signals from an accurate crystal controlled oscillator 'D' operating at 100 KhZ.

The sum and difference signals are fed to a low-pass filter 'E' arranged to pass only the difference signals, which will be at a frequency of 80 or 32 Hz. The pass band might be 0-100 Hz.

The difference frequency signals are fed to a pair of counters 'F' and 'G' each of which is arranged to count the difference frequency pulses over a time interval set by a timer 'H' the interval being for example, 0.25 seconds.

A signal from the timer 'H' starts the two counters 'F' and 'G', and the timer is also connected to a data transfer pulse unit 'K' for triggering a data latch 'P' and a reset timer 'J'. Thus, after the timer 'H' has completed its count, the data latch 'P' is operated and the reset timer 'J' resets the counters 'F' and 'G' ready for another count.

If during the quarter-second counting period, eight pulses have been received at 'F', corresponding to a frequency difference of 32 Hz, there will be a signal on two of the output connections of the counter 'F' for driving an AND gate 'L' to deliver a signal to an OR gate 'N'. Likewise if eighty pulses have been received during the quarter second period, there will be a signal on one output terminal of each of the counters 'F' and 'G' for driving an AND gate 'M' to provide another input to the OR gate 'N'.

The result will be that when the data latch 'P' is triggered from 'K', there will be a 'one' at the output of the OR gate 'N' if either eight or twenty pulses have been received by the counters but not if any other number of pulses has been received. That 'one' at the output of 'N' will be delivered at 'Z' to indicate that access should be given.

It may then be arranged that a lock is automatically released, or an alarm system is inhibited, or that a door is automatically opened, or a machine is rendered operative, for example.

If two tokens are present at 'A', for example, transmitting at respective frequencies of 100032 Hz and 99920 Hz, then the automatic gain control of the amplifier 'B' will tend to lock onto one of the frequencies - the predominant frequency if one is more intense than the other - and it will only be the difference frequency from that one particular frequency that is fed from the low-pass filter 'E' to the counters 'F' and 'G', and the fact that the second particular frequency is present will be ignored.

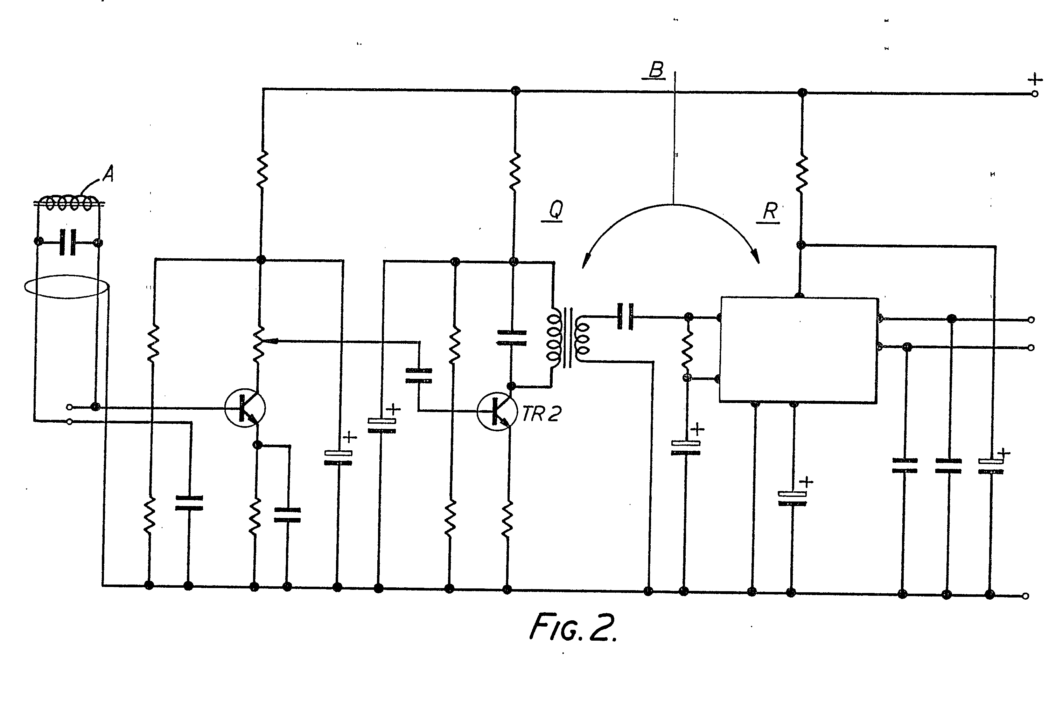

FIGURE 2 is a circuit diagram of the amplifier 'B' which has negative feed back provided in a stage including a transistor TR2 to give automatic gain control

There are two tuned stages, these being the ferrite rod pick up stage 'A' and a transformer coupling stage 'Q'. Additionally part of the amplifier consists of a heavily biased stage 'R' which 'clips' very easily and tends to provide a small amount of positive feed-back when a sufficiently strong signal is detected. Subsequent signals are very attenuated, and the amplifier tends to produce an output only in response to the first signal received.

Of course if at a location, access is only to be given to a person with a transmitter at one frequency, the counter logic circuit will be simpler and arranged to give a signal at 'Z' in response to an output from a single counter and gate such as 'F' and 'L'.

With the arrangement shown, the connections between the gates 'L' and 'M' and the counters 'F' and 'G' can be easily re-arranged if the second requirements change, or the frequencies change.

It will be appreciated that if there are a number of tokens, transmitting at frequencies which are not very different from each other, some of which are required to give access at a particular location while others are not, it is very much easier to distinguish between the difference beat frequencies for the various signals
by the counter logic circuit described,than between
the higher transmitted frequencies.

Thus, a frequency of say 100040 would produce a
beat difference frequency of 40 and a count over 0.25 secs
of 10 which would not provide an output at 'Z'.

The receiver can be adjusted for a different
frequency by altering the count of the counters
or by altering the interval of the count timer.

CLAIMS

1. A radio frequency detector including a radio frequency receiver and amplifier, and a mixer arranged to mix the amplifier output with an accurate local frequency signal, a low-pass filter of the mixer output , and means responsive to the filter output arranged to give an "accept" or "refuse" signal in dependence on whether or not a particular frequency, or one of a number of particular frequencies,is present .

2. A detector as claimed in Claim 1 in which the responsive means includes a counter arranged to count the filter output over a predetermined time interval.

3. A detector as claimed in Claim 2 in which the responsive means is arranged to give an "accept" signal if any of a number of alternative counts is achieved.

4. A detector as claimed in Claim 3 in which the responsive means includes two counters, and logic gates coupled to output terminals of the counters.

5. A detector as claimed in any of Claims 2-4 including a count timer arranged after the predetermined time interval to operate a latch for the counter output, and to reset the counter.

6.    A detector as claimed in any of the preceding claims in which the radio frequency amplifier is highly selective.

7.    A detector as claimed in any of the preceding claims in which the radio frequency amplifier has automatic gain control.

8.    An access control system including a detector as claimed in any of the preceding claims, and a number of pocket tokens capable of transmitting at different, but close radio frequencies.

9.    A system as claimed in Claim 8 in which the local frequency is close to, but different from the radio frequencies.

FIG. I.

FIG. 2.

European Patent Office

**EUROPEAN SEARCH REPORT**

| | DOCUMENTS CONSIDERED TO BE RELEVANT | | CLASSIFICATION OF THE APPLICATION (Int. Cl.³) |
|---|---|---|---|
| Category | Citation of document with indication, where appropriate, of relevant passages | Relevant to claim | |
| X | GB - A - 1 387 519 (TULL AVIA-TION)<br><br>+ Fig.; page 1, lines 11-22; page 1, line 56 - page 4, line 56 +<br><br>-- | 1-3,5 | G 01 R 23/15<br>H 04 B 5/04 |
| | DE - A - 2 356 961 (SCHLUMBERGER)<br><br>+ Fig. 1; page 5, line 4 - page 7, line 16 +<br><br>& AU-A1-62 732/73<br><br>-- | 1,2,5, 9 | |
| | US - A - 4 137 497 (LOWENSCHUSS)<br><br>+ Fig. 1; abstract +<br><br>-- | 1,2,4, 5,9 | TECHNICAL FIELDS SEARCHED (Int. Cl.³)<br><br>G 01 R 23/00<br>G 07 C 9/00<br>G 08 B 13/00<br>H 03 J 1/00<br>H 03 J 7/00<br>H 04 B 5/00<br>H 04 H 5/00 |
| | GB - A - 1 487 073 (PENTEL KABU-SHIKI KAISHA)<br><br>+ Fig. 1-3; page 1, line 36 - page 3, line 13 +<br><br>-- | 1-3,5, 6,8,9 | |
| | US - A - 4 063 169 (PALMER)<br><br>+ Fig. 1; abstract +<br><br>-- | 1,2,5 | |
| | WERNER W. DIEFENBACH "Praxis der Rundfunk-Stereofonie", 1965, VERLAG FÜR RADIO-FOTO-KINOTECHNIK GMBH, Berlin-Borsigwalde pages 88,89<br><br>+ Function units T4, T6, T24 +<br><br>---- | 1,7,9 | CATEGORY OF CITED DOCUMENTS<br><br>X: particularly relevant<br>A: technological background<br>O: non-written disclosure<br>P: intermediate document<br>T: theory or principle underlying the invention<br>E: conflicting application<br>D: document cited in the application<br>L: citation for other reasons |

| X | The present search report has been drawn up for all claims | | &: member of the same patent family, corresponding document |
|---|---|---|---|
| Place of search<br>VIENNA | Date of completion of the search<br>08-04-1981 | Examiner<br>DRÖSCHER | |

EPO Form 1503.1 06.78